# EUROPÄISCHE PATENTSCHRIFT

(11) **EP 0 282 835 B1**
(45) Veröffentlichungstag und Bekanntmachung des Hinweises auf die Patenterteilung: **13.10.1993**
(21) Anmeldenummer: 88103332.8
(22) Anmeldetag: 04.03.1988
(51) Int. Cl.: C23C 14/54, H01J 37/34

(54) **Verfahren und Vorrichtung zur Regelung der reaktiven Schichtabscheidung auf Substraten mittels Magnetronkatoden**
Process and device for controlling the reactive coating of substrates with layers, using magnetron cathodes
Procédé et dispositif de contrôle du dépôt réactif de couches sur des substrats au moyen de cathodes magnétron

(30) Priorität: 20.03.1987 DE 3709177
(43) Veröffentlichungstag der Anmeldung: 21.09.1988
(73) Patentinhaber: LEYBOLD AKTIENGESELLSCHAFT, D-63450 Hanau (DE)
(72) Erfinder: Thomas, Friedrich-Werner, Dipl.-Ing.Dr., D-6460 Gelnhausen (DE); Wirz, Peter, Dipl.-Phys.Dr., D-6296 Waldernbach (DE)

(56) Entgegenhaltungen:
- US-A- 4 166 784
- US-A- 4 407 709
- US-A- 4 704 199

## Beschreibung

Die Erfindung betrifft ein Regelverfahren nach dem Oberbegriff des Patentanspruchs 1.

Bei derartigen Beschichtungsverfahren wird üblicherweise ein elektrisch leitfähiges Target, meist ein metallisches Target, in reaktiver Atmosphäre zerstäubt, um die Magnetronkatode mit Gleichspannung versorgen zu können. Auf dem Substrat scheidet sich dann eine Schicht aus dem Reaktionsprodukt des Targetmaterials ab, wobei die Zusammensetzung des Schichtmaterials sehr weitgehend von der Atmosphäre in der Umgebung der Magnetronkatode abhängt.

Man unterscheidet bei derartigen Beschichtungsverfahren drei unterschiedliche Betriebsbedingungen für die Magnetronkatode, nämlich, den "metallischen Betrieb", den "reaktiven Betrieb", und den "Übergangsbetrieb". Beim "metallischen Betrieb" hat die Zerstäubungsfläche des Targets metallischen, d.h. leitfähigen Charakter. Beim "reaktiven Betrieb" befindet sich auf der Zerstäubungsfläche des Targets ein entsprechendes Reaktionsprodukt, das in der Regel einen elektrischen Isolator darstellt und die Zerstäubungsrate, d.h. die pro Zeiteinheit zerstäubte Menge des Targetmaterials, deutlich herabsetzt. Der "Übergangsbetrieb" liegt zwischen diesen beiden Betriebszuständen und ist sehr weitgehend als instabil anzusehen, weil er entweder in der einen oder in der anderen Richtung umzukippen droht. Dieser "Übergangsbetrieb" ist eine typische Eigenschaft von Magnetronkatoden, bei denen sich in der Zerstäubungsfläche durch den örtlich begrenzten Zerstäubungsvorgang ein zunehmend tiefer werdender Erosionsgraben ausbildet. Während die Wandflächen des Erosionsgrabens durch die hohe Zerstäubungsrate noch sehr weitgehend frei von Reaktionsprodukten gehalten werden können, belegt sich die restliche Targetfläche mit den Reaktionsprodukten, so daß das bereits beschriebene instabile Betriebsverhalten auftritt.

Um das instabile Betriebsverhalten soweit wie möglich zu verhindern bzw. zu unterdrücken, ist es bereits bekannt, das Reaktionsgas an einer von der Targetoberfläche entfernten und durch eine Blende abgeschirmten Stelle zuzuführen, und im Bereich des Targets lediglich ein die Zerstäubung bewirkendes Inertgas zuzuführen (DE-OS 33 31 707). Würde man bei einer solchen Maßnahme die Zufuhr des Reaktionsgases in Abhängigkeit von der Intensität einer oder mehrerer Spektrallinien durchführen, so ergäben sich für ein solches Regelverfahren außerordentlich lange Zeitkonstanten, die für ein Produktionsverfahren nicht akzeptiert werden können, insbesondere nicht für ein kontinuierliches Produktionsverfahren. Außerdem findet in einem solchen Falle ein langsames Pendeln zwischen dem "metallischen Betrieb" und dem "reaktiven Betrieb" statt, weil insbesondere der Abbau des Reaktionsproduktes auf der Zerstäubungsfläche des Targets wegen der hierbei sehr niedrigen Zerstäubungsrate relativ sehr lange dauert.

Es wurde bereits erkannt, daß dieses Pendeln zwischen dem "metallischen Betrieb" und dem "reaktiven Betrieb" sich durch eine Hysterese-Kurve ausdrücken läßt, wenn man den das stöchiometrische Verhältnis überschreitenden Reaktionsgasstrom über dem Reaktionsgasstrom aufträgt (EP-OS 0 121 019). Selbst ein hierauf aufbauendes Regelverfahren führt unter Einschaltung eines Massenspektrometers nicht zu einer Beseitigung der Instabilitätsprobleme, weil hierfür die Zeitkonstanten der einzelnen Glieder der Meß- und Regelstrecke zu lang sind.

Bei reaktiven Beschichtungsverfahren geht es in der Regel darum, eine chemische Verbindung mit den geforderten Schichteigenschaften herzustellen. Diese Schichteigenschaften sind mit engen Toleranzen und großer Langzeitstabilität herzustellen. Es sind bereits eine ganze Reihe von Vorschlägen gemacht worden, um mit Hilfe von Regelkreisen mit einem Sensor für eine bestimmte Schichteigenschaft einen Prozeßparameter der Magnetron-Zerstäubung zu regeln. Alle Vorschläge haben jedoch nur zu einem sehr begrenzten Erfolg geführt. Viele Schichteigenschaften lassen sich nämlich in der Beschichtungszone nicht oder wegen der Beeinflussung der Meßsignale durch das Plasma nur sehr ungenau messen. Man hat daher bei derartigen Regelkreisen die Messung stets außerhalb der Beschichtungszone durchgeführt. Nachteilig für die Erzielung enger Toleranzen bei dieser Verfahrensweise ist die Zeitdifferenz zwischen der Beendigung des Beschichtungsvorgangs und der Messung. Da die Zeitkonstante im Interesse der Stabilität des Regelkreises wesentlich größer als die genannte Zeitdifferenz gewählt werden muß, ergeben sich große Substratbereiche, die mit unzulässigen Toleranzen beschichtet werden. Diese Substratbereiche können sich über mehrere Substrate oder - bei der Folienbeschichtung - über größere Folienlängen erstrecken, die infolgedessen als Ausschuß erklärt werden müssen.

Noch wesentlicher als die bereits genannten Nachteile bei der Regelung mittels des Meßwertes einer Schichteigenschaft ist der Nachteil zu sehen, daß solche Regelkreise die Prozeßstabilität der reaktiven Schichtabscheidung nicht gewährleisten. Ursachen solcher Prozeßinstabilitäten sind z.B. unerwünschte Änderungen der Gaszusammensetzungen und Bogenentladungen am Target, die sich auch in Änderungen der Eigenschaften der abgeschiedenen Schichten äußern. Solche Instabilitäten können bis zum Umkippen des Prozesses aus dem "metallischen Betrieb" in den "reaktiven Betrieb" führen. Ein Umkippen des Beschichtungsprozesses während der Beschichtung eines Substrats bedeutet hinsichtlich der Schichteigenschaften einen vollständigen Ausschuß.

Das genannte Umkippen erfolgt bei ansonsten konstanten elektrischen Zerstäubungsparametern bei einem kritischen Reaktionsgasfluß. Die Höhe dieser Flußrate ist ein Maß für die Grundstabilität des reaktiven Prozesses. Ist der Reaktionsgasfluß kleiner als der kritische Fluß, so arbeitet die Magnetronkatode im sogenannten "metallischen Bereich", in dem die Entladung mit sehr einfachen Mitteln stabilisiert werden kann. In diesem Betriebsbereich werden die geforderten Schichteigenschaften im allgemeinen durch Konstanthalten von Prozeßparametern, wie z.B. Leistung und Reaktionsgasfluß sowie durch eine Zeitsteuerung erzielt.

Hingegen ist es im "metallischen Bereich" im allgemeinen nicht möglich, Schichten aus Reaktionsprodukten mit der geforderten Stöchiometrie abzuscheiden. Mit speziellen Maßnahmen zur Entkopplung der Einwirkung des Reaktionsgases auf das Target bzw. am Substrat wird die Herstellung solcher Schichten mit entsprechend niedriger Rate möglich (siehe z.B. die bereits genannte DE-OS 33 31 707).

Bei den vorstehend beschriebenen Verfahrensweisen zur Erzielung der geforderten Schichteigenschaften wurden der Reaktionsgasfluß und/oder ein elektrischer Betriebsparameter konstant gehalten bzw. geregelt.

Bei einer Regelung des Prozesses mit Hilfe einer gemessenen Schichteigenschaft ist jedoch nicht nur die bereits genannte Zeitverzögerung von der Vollendung der Schicht bis zur Messung von Nachteil, vielmehr wirkt sich noch kritischer die zeitliche Hysterese der Targetbedeckung aus. Notwendige Änderungen der Targetbedeckung, die beispielsweise bei einer Änderung der Leistung auftreten, können eine zeitliche Verzögerung bewirken, die größer ist als der genannte Zeitabstand, der eine Folge der Anordnung der Meßstelle für die Schichtparameter ist. Diese Zeitverschiebung kann zwischen mehreren Sekunden und einigen Minuten liegen, so daß unzulässige Änderungen der Schichteigenschaften die Folge sind.

Aus wirtschaftlichen Gründen können im allgemeinen Schichten mit hohem Reaktionsgrad der Verbindung und mit hoher Niederschlagsrate nur im sogenannten "Übergangsbetrieb" erreicht werden, der ein instabiler oder metastabiler Betriebszustand des Zerstäubungsprozesses ist, worauf bereits weiter oben hingewiesen wurde. Im Erosionsgraben des Targets wird die Belegung mit Reaktionsprodukten gerade noch verhindert, während sich am Substrat die Reaktionsprodukte mit hohem Reaktionsgrad und hoher Rate abscheiden. Das Arbeiten im "Übergangsbetrieb" erfordert die Stabilisierung der Entladung mit zusätzlichen Mitteln.

Durch die US-A-4 166 784 ist bereits ein Verfahren nach dem Oberbegriff des Patentanspruchs 1 bekannt, bei dem ein einziger Regelkreis für die Gaszufuhr in Abhängigkeit von einem manuell eingestellten Sollwert eine möglichst kurze Zeitkonstante aufweist. Um einem erhöhten Reaktionsgasdruck entgegenzuwirken, werden zwei Korrekturmaßnahmen beschrieben, nämlich der Verbrauch an Reaktionsgas durch eine vorübergehend erhöhte Zerstäubungsleistung sowie eine gleichzeitige Absteuerung des Reaktionsgases an Atmosphäre.

Durch die DD-PS 239 810 ist es bekannt, aus einer plasmaentladung Lichtstrahlung auszukoppeln und eine Spektrallinie oder eine Gruppe von Spektrallinien zur Signalbildung heranzuziehen, um eine Regelung des Gasflusses durchzuführen. Durch die DD-PS 239 811 ist es weiter bekannt, auf welche Weise man ein Referenzsignal für die Fixierung der Lage des Arbeitspunktes finden kann.

Regelkreise zur Sicherung der Prozeßstabilität eines vorgegebenen Arbeitspunktes der Entladung bei einem reaktiven Katodenzerstäubungsprozeß unter Nutzung eines Emissionssignals können jedoch im allgemeinen nicht vermeiden, daß die Schichteigenschaften unzulässige Toleranzen aufweisen,und/oder sich über längere Zeit verschieben. Dafür gibt es eine Reihe von Ursachen:
- Beim Einbringen neuer Substratflächen in den Beschichtungsbereich werden durch die Einwirkung des Plasmas auf das Substrat Oberflächenschichten freigesetzt. Hierdurch ändert sich in der Entladung die Gaszusammensetzung und infolgedessen auch das Emissionssignal in kontrollierbarer Weise.
- Desorptionsprozesse von Anlagenteilen nach einem Targetwechsel bewirken ebenfalls unerwünschte Änderungen in den Emissionssignalen. Kritisch an dieser Erscheinung sind ihre Unkontrollierbarkeit und Wirksamkeit über längere Zeiten im Stundenbereich.
- Weiterhin bewirken alle geometrischen Veränderungen während des Beschichtungsprozesses, insbesondere die fortschreitende Targeterosion, störende Änderungserscheinungen des Emissionssignals.

Der Erfindung liegt daher die Aufgabe zugrunde, ein Verfahren der eingangs beschriebenen Art anzugeben, mit dem es möglich ist, bei einem reaktiven Beschichtungsverfahren Schichteigenschaften gezielt und mit enger Toleranz zu erreichen.

Die Lösung der gestellten Aufgabe erfolgt erfindungsgemäß durch die im Kennzeichen des Anspruchs 1 angegebenen Maßnahmen.

Wichtig ist dabei, daß die Messung mindestens einer Spektrallinie im Plasma zwischen Target und Substrat erfolgt. Es handelt sich dabei um eine optische Messung, d.h. um eine Messung durch ein Spektralfotometer, das unmittelbar auf das Plasma ausgerichtet ist. Dies bedeutet bei Verwendung einer Magnetronkatode die Ausrichtung des optischen Sensors auf Volumenelemente in großer Nähe der Targetoberfläche. Der Bereich, in dem die Messung parallel zur Targetoberfläche durchgeführt wird, liegt vorzugsweise etwa 10 bis 30 mm von der Targetoberfläche entfernt.

Die Genauigkeit einer solchen Messung unterscheidet sich auch deutlich von einer Messung durch ein Massenspektrometer, bei dem Volumenelemente der Gasatmosphäre aus dem Beschichtungsbereich abgesaugt und an einer davon entfernten Stelle analysiert werden. Diese Meßmethode ist mit einer beträchtlichen Zeitverzögerung behaftet und hat darüberhinaus den Nachteil, daß sich die Gaszusammensetzung auf dem Transportwege verändern kann.

Die Regelung des Reaktionsgaseinlasses mit kürzest möglicher Zeitkonstante ist im Zusammenhang mit dem Einlaß des Reaktionsgases in Targetnähe zu sehen Auf diese Weise ist es möglich, den Reaktionsgasfluß in sehr kurzer Zeit etwa geänderten Betriebsbedingungen anzupassen.

Die Messung mindestens einer Eigenschaft der fertigen Schicht erfolgt dabei notwendigerweise mit einer deutlich längeren Zeitkonstante, da nämlich zunächst das Substrat mit der fertigen Schicht aus der Beschichtungszone zur Meßzone transportiert werden muß. Es erfolgt hier also mit langsamerer Geschwindigkeit eine Anpassung des Sollwerts. Diese Maßnahme ist aber wie die Erfahrung gezeigt hat - für die Lösung der Aufgabe vollständig ausreichend.

Es handelt sich also im Prinzip um die Überlagerung von zwei Regelkreisen, von denen der eine eine außerordentlich kurze und der andere eine merklich größere Zeitkonstante aufweist. Durch die unterschiedliche Gewichtung des Einflusses der Meßsignale auf der Plasmaseite einerseits und auf der Substratseite andererseits kann die Stabilität des gesamten Regelverhaltens deutlich verbessert werden. So ist es beispielsweise möglich, den Anteil des Meßsignals aus dem Plasma mit 60 bis 90 % zu bewerten und den Anteil des Meßsignals aus der Substratmessung mit 10 bis 40 %.

Die erfindungsgemäße Verfahrensweise, eine erforderliche Prozeßstabilität einerseits und gleichzeitig die erforderliche Konstanz der Schichteigenschaften andererseits mit prinzipiell unterschiedlichen Mitteln zu erreichen, hat sich als äußerst wirksame Lösung der gestellten Aufgabe erwiesen. Es hat sich gezeigt, daß eine qualitative Verbesserung der Plasma-Emissionsregelung zur Prozeßstabilisierung ermöglicht wird, wenn die Zeitkonstante des betreffenden Regelkreises so kurz wie möglich gehalten wird. Die Verringerung der Zeitkonstanten dieses Regelkreises läßt sich jedoch nur erreichen, wenn die zeitliche Trägheit der Zufuhr des Reaktionsgasflüsses überwunden wird.

Kurze Diffusionswege des Reaktionsgases vom Einlaß bis in den Bereich des dichten Plasmas in der magnetischen Falle über dem Erosionsprofil werden durch den Reaktionsgaseinlaß in möglichst großer Nähe des Targets gesichert. Diese Art des Einlasses, bei der der Target- und der Substratbereich sehr eng gekoppelt sind, hätte ohne die Regelung mit gleitendem Sollwert eine drastische Erniedrigung der Grundstabilität der Entladung zur Folge. Die enge Koppelung zwischen dem Einlaß des Reaktionsgases und der Targetoberfläche widerspricht dem standardmäßig praktizierten Lösungweg einer weitgehenden Entkopplung zwischen Target und Substratbereich im Interesse einer hohen Grundstabilität.

Die kurze Zeitkonstante und damit die enge Rückführung des Meßsignals aus dem Plasma erlauben in Verbindung mit der gleitenden Sollwertregelung den stabilen Betrieb in willkürlich gewählten Arbeitspunkten im "Übergangsbereich". Dies bedeutet in der Praxis den Gewinn verfahrenstechnischer Freiheitsgrade, z.B. für die Erzielung von Schichten mit in großer Variationsbreite definiert einstellbaren Schichteigenschaften. So läßt sich beispielsweise der Brechungsindex für Aluminium-Nitrid-Schichten im Bereich von 1,95 bis 2,1 variieren. Bei der Herstellung von Indium-Zinn-Oxidschichten läßt sich der spezifische Widerstand um Größenordnungen variieren.

Verstärkt man die durch die Plasma-Emissionsregelung verbundene Kopplung zwischen dem Target- und dem Substratbereich noch weiterhin, so können sogar mit herkömmlichen Mitteln nicht erreichbare Schichteigenschaften erzeugt werden. So werden beispielsweise Indium-Zinn-Oxid-Schichten auf ungeheizten Substraten mit Flächenwiderständen unter 1 x 10⁻⁴ Ohm/cm gegenüber 8 x 10⁻⁴ Ohm/cm bei herkömmlichen Methoden erzielt.

Eine Erklärung dafür, daß bei der erfindungsgemäßen Verfahrensweise trotzdem die Entladung stabil aufrecht erhalten werden kann, kann darin gesehen werden, daß bei der engen Kopplung der in die gewünschte chemische Verbindung umgesetzte Anteil des Reaktionsgases relativ ansteigt, weil auch die Anregung des Reaktionsgases in der Nähe des Substrates ansteigt. Andererseits hat die enge Kopplung und die damit reduzierte Grundstabilität zur Folge, daß Änderungen der Gaszusammensetzung in Folge von Desorptionsvorgängen zu einer verstärkten Beeinflussung des Emissionssignals und damit der Schichteigenschaften führen.

Durch die enge Kopplung der Teilprozesse am Target einerseits und am Substrat andererseits durch das erfindungsgemäße Regelverfahren wird außerdem der Einfluß des Erosionszustandes des Targets, dessen Änderung zu einer Verschiebung der Zerstäubungsrate und der Anregung des Reaktionsgases führt, auf die Schichteigenschaften relativ größer. Die durch beide Effekte hervorgerufene Verschiebung der Schichteigenschaften hat jedoch eine große Zeitkonstante und kann durch die erfindungsgemäße Koppelung des Regelverfahrens über die gleitende Verstellung des Sollwerts wirksam verhindert werden.

Weitere vorteilhafte Ausgestaltungen des Erfindungsgegenstandes ergeben sich aus den Unteransprüchen. So ist es besonders vorteilhaft, daß das erfindungsgemäße Regelverfahren erst nach Ablauf der Konditionierung der Targetoberfläche durchgeführt wird. Hierunter versteht man die Reinigung der Oberfläche eines neuen Targets oder eines solchen Targets, das der Umgebungsluft ausgesetzt war.

Hierbei verfährt man in besonders vorteilhafter Weise so, daß nach Ablauf einer Konditionierung der Targetoberfläche Prozeßparameter in der Nähe des Arbeitspunktes für die geforderten Schichteigenschaften eingestellt werden, indem der Reaktionsgaszufluß zeitlich programmiert und monoton in einer vorgegebenen Einstellzeit erhöht wird, bis ein den Sollwert der mindestens einen Schichteigenschaft in etwa bestimmender Fluß des Reaktionsgases erreicht wird.

Es ist dann weiterhin besonders vorteilhaft, wenn ein nach Ablauf von Konditionierzeit und Einstellzeit für den Fluß des Reaktionsgases gewonnener Istwert für das mindestens eine Intensitätssignal mit dem Sollwert für die Schichteigenschaften verglichen und aus dem Vergleichswert der Sollwert für den ersten Regelkreis gebildet wird.

Die nach Ablauf der Konditionierung gemessene Intensität der Emission charakterisiert einen definierten Ausgangszustand. Der Arbeitspunkt im reaktiven Betrieb, bei dem die geforderte Schichteigenschaft erreicht wird, wird anfänglich durch einen Referenzwert als Intensitätswert charakterisiert, der aufgrund von Vorversuchen ermittelt wird.

Die Erfindung betrifft auch eine Magnetronbeschichtungsvorrichtung zur Durchführung des eingangs beschriebenen Verfahrens. Zur Lösung der gleichen Aufgabe ist diese Vorrichtung dadurch gekennzeichnet, daß
a) ein optischer Sensor einer Spektralfotometeranordnung in den Raum zwischen Magnetronkatode und Substrat gerichtet ist, wobei der Strahlengang des Sensors parallel zur Targetoberfläche ausgerichtet und im Abstand von 10 bis 30 mm von dieser geführt ist,
b) eine Gasverteilungseinrichtung in der Nähe der Targetoberfläche angeordnet ist, die über ein Regelventil mit einer Quelle für das Reaktionsgas verbunden ist,
c) der Ausgang der Spektralfotometeranordnung über einen Verstärker und einen Regler mit einem Stellglied für das Regelventil verbunden ist, wobei optischer Sensor, Spektralfotometeranordnung, Verstärker, Regler, Stellglied und Regelventil einen ersten Regelkreis mit kurzer Zeitkonstante bilden,
d) im Wege des unmittelbar zuvor beschichteten Substrats ein zweiter Sensor für mindestens eine Eigenschaft des beschichteten Substrats angeordnet ist, wobei der Ausgang des zweiten Sensors einem zweiten Verstärker aufgeschaltet ist, dessen Ausgang einem Sollwertgeber für den Regler aufgeschaltet ist und wobei der zweite Sensor, der zweite Verstärker, der Sollwertgeber, der Regler, das Stellglied und das nachgeschaltete Regelventil einen zweiten Regelkreis mit längerer Zeitkonstante als die des ersten Regelkreises bilden, und wobei der erste und der zweite Regelkreis im Regler zusammengeschaltet sind.

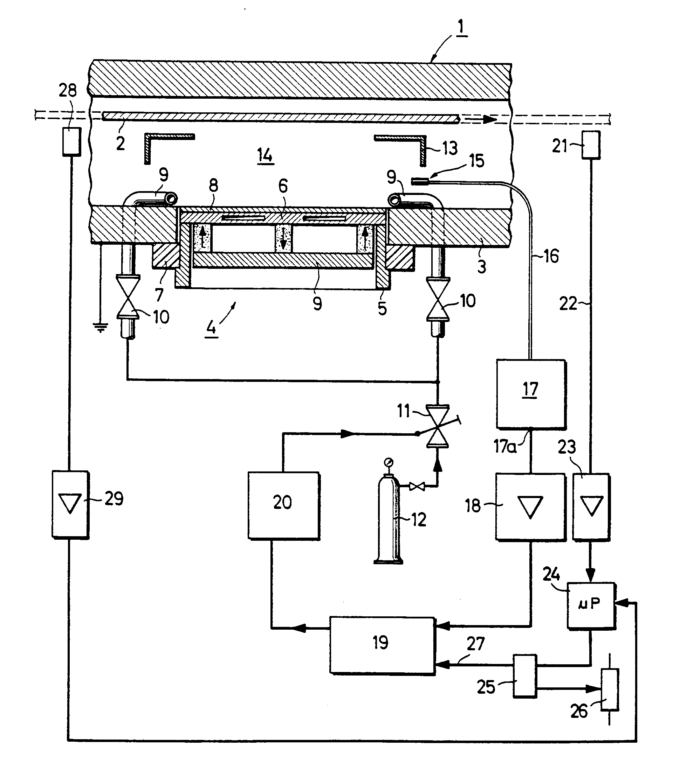

Ein Ausführungsbeispiel des Erfindungsgegenstandes wird nachfolgend anhand der einzigen Figur näher erläutert.

In der Figur ist ein Ausschnitt aus einer Vakuumkammer 1 dargestellt, durch die hindurch ein Substrat 2 entlang einer Bewegungsbahn geführt wird, die durch gestrichelte Linien angedeutet ist. In einer Bodenplatte 3 der Vakuumkammer befindet sich unter Einhaltung eines allseitigen Isolationsabstandes, der kleiner ist als der unter den Betriebsbedingungen zu beobachtende Dunkelraumabstand, eine Magnetronkatode 4, die aus folgenden Teilen besteht: Ein Katodengrundkörper 5 mit einer Stirnplatte 6 ist unter Zwischenschaltung eines Isolierstoffringes 7 in die Bodenplatte 3 eingesetzt. Auf der Oberseite der mit Kühlkanälen versehenen Stirnplatte 6 befindet sich ein Target 8 aus einem elektrisch leitfähigen Material, das die eine Komponente des Schichtmaterials darstellt. Auf der Unterseite der Stirnplatte 6 befindet sich ein Magnetsystem 9, das aus einer ferromagnetischen Jochplatte und ineinanderliegend darauf angeordneten Permanentmagneten besteht, wobei die innen und außen liegenden Magnete jeweils eine entgegengesetzte Pollage aufweisen, was durch die eingezeichneten Pfeile dargestellt ist. Im unmittelbaren Randbereich des Targets 8 befindet sich eine Gasverteilungseinrichtung 9, die jedoch - in der Draufsicht gesehen - das Target 8 gerade eben nicht überdeckt. Die Gasverteilungseinrichtung 9 besteht aus einer oder zwei Rohrleitungen, die die Peripherie des Targets zumindest auf einem wesentlichen Teil des Umfangs begleiten und Perforationslöcher aufweisen, durch die das Reaktionsgas in Richtung auf das Target austreten kann. Die Gasverteilungseinrichtung 9 ist über Drosselventile 10 und ein gemeinsames Regelventil 11 mit einer Quelle 12 für ein Reaktionsgas oder ein Gemisch aus einem Reaktionsgas und einem Arbeitsgas (Argon) verbunden. Die Spannungsquelle für die Versorgung der Magnetronkatode 4 mit einer negativen Gleichspannung zwischen 400 und 1000 Volt ist der Einfachheit halber nicht dargestellt.

Zwischen der Magnetronkatode 4 und dem Substrat 2 ist in der Nähe des Substrats eine Abschirmungseinrichtung 13 angeordnet, die auch eine Anodenfunktion ausüben kann und entweder auf gleichem Potential wie die Vakuumkammer oder auf einem darüberliegenden positiven Potential liegen kann. Durch das Target 8, das Substrat 2 und die Abschirmungseinrichtung 13 wird im wesentlichen eine Reaktionszone 14 begrenzt, in der sich ein reaktiver Prozeß zur Beschichtung des Substrats 2 mit einer Verbindung aus dem Targetmaterial und dem Reaktionsgas abspielt.

Auf diese Reaktionszone ist ein optischer Sensor 15 ausgerichtet, der durch einen parallel zum Target 8 verlaufenden Strahlengang einen engen Bereich der Reaktionszone 14 ausblendet. Dieser Strahlengang befindet sich in einem Bereich von 10 bis 30 mm oberhalb des Targets 8. Von dem optischen Sensor 15 führt ein Glasfaserkabel 16 zu einer Spektralfotometeranordnung 17, die beispielhaft aus einem opto-elektronischen Wandler mit Interferenzfilter oder aus einem verstellbaren Monochromator bestehen kann. Dadurch gelingt es, aus dem Lichtsignal des Sensors 15 eine oder mehrere Spektrallinien auszusondern und ihrer Intensität nach zu erfassen. Am Ausgang 17a der Spektralfotometeranordnung steht infolgedessen ein elektrisches Signal an, das der Intensität der Spektrallinie(n) proportional ist.

Der Spektralfotometeranordnung ist ein Verstärker 18 nachgeschaltet, dem wiederum ein Regler 19 folgt, der seinerseits auf ein Stellglied 20 für das Regelventil 11 einwirkt. Diese Anordnung bildet einen ersten Regelkreis mit außerordentlich kurzer Zeitkonstante, die kleiner als 150 ms ist. Dadurch läßt sich die Zusammensetzung der Gasatmosphäre bzw. des Plasmas in der Reaktionszone 14 in kürzester Zeit ausregeln.

Im Wege des Substrats 2 befindet sich hinter dem Austritt aus der Reaktionszone 14 ein zweiter Sensor 21, der je nach der zu messenden Schichteigenschaft ein optischer und/oder ein elektrischer Sensor sein kann. Das Ausgangssignal dieses Sensors wird über eine Leitung 22 einem weiteren Verstärker 23 zugeführt, dessen Ausgang wiederum einem Mikroprozessor 24 aufgeschaltet ist. Von diesem Mikroprozessor führt eine weitere Leitung zu einem Sollwertgeber 25, der durch eine Stellvorrichtung 26 (Potentiometer) eine Voreinstellung erhält. Da der Sensor 21 gewisse Veränderungen der Schichteigenschaften des Substrats 2 registriert, ergibt sich hieraus, daß am Ausgang des Sollwertgebers 25 ein sogenannter gleitender Sollwert ansteht, der über eine Leitung 27 dem Regler 19 zugeführt wird. Im Regler 19 werden infolgedessen Signale regelungstechnisch miteinander verknüpft, die den Ausgangssignalen der Sensoren 15 und 21 entsprechen. Da die Eigenschaften der fertigen Schicht erst mit einer Zeitverzögerung vom Sensor 21 erfaßt werden können, die der Bewegungsgeschwindigkeit des Substrats 2 entspricht, tritt das den Schichteigenschaften entsprechende Meßsignal erst mit einer Zeitverzögerung auf, die groß ist im Verhältnis zur Zeitkonstante des ersten Regelkreises. In aller Regel wird die Verzögerung mindestens 0,5 Sekunden betragen. Die Elemente vom Sensor 21 über den Sollwertgeber 25 bis zum Regelventil 11 stellen einen zweiten Regelkreis mit großer Zeitkonstante dar, wobei Teile des ersten und des zweiten Regelkreises ab dem Regler 19 identisch sind.

Weiterhin ist im Wege des Substrats 2 unmittelbar vor der aus der Magnetronkatode 4 gebildeten Beschichtungsstation mit der Reaktionszone 14 ein dritter Sensor 28 für die Erfassung der Eigenschaften des in die Beschichtungsstation einlaufenden Substrats angeordnet, der über einen dritten Verstärker 29 dem Mikroprozessor 24 aufgeschaltet ist. Im Mikroprozessor 24 findet ein Vergleich der Signale der Sensoren 21 und 28 statt, so daß nur die Veränderungen der Eigenschaften des Substrats in der Beschichtungsstation mit der Reaktionszone 14 erfaßt werden. Diese Maßnahme ist unter anderem für den Fall wichtig, daß der Beschichtungsstation mit der Reaktionszone 14 noch eine weitere Beschichtungsstation vorgeschaltet ist, so daß das Substrat mit einer oder mehreren vorausgegangenen Beschichtungen in die Reaktionszone 14 einläuft.

## Patentansprüche

1. Verfahren zur Regelung der reaktiven Schichtabscheidung auf Substraten bei Verwendung von Magnetronkatoden mit Targets aus mindestens einer elektrisch leitfähigen Komponente des Schichtmaterials unter Auswertung der Intensität mindestens einer Spektrallinie des Targetmaterials, die im Plasma eines Zerstäubungsvorganges zwischen Target und Substrat gemessen wird, und mit in Abhängigkeit von dieser Intensität während des Schichtaufbaus mit kürzest möglicher Zeitkonstante durch einen ersten Regelkreis geregelten Reaktionsgaseinlaß unter Vorgabe eines Sollwerts für die genannte Intensität, **dadurch gekennzeichnet,** daß
a) die Magnetronkatode mit konstanter Leistung betrieben wird,
b) die Reaktionsgasverteilung in Targetnähe bewirkt wird und
c) der genannte Sollwert in Abhängigkeit von mindestens einer Eigenschaft der fertigen Schicht durch einen zweiten Regelkreis in der Weise gleitend verstellt wird, daß die vorgegebene Schichteigenschaft soweit wie möglich konstant gehalten wird, indem dem zweiten Regelkreis ein aus der mindestens einen Eigenschaft der fertigen Schicht gewonnenes Meßsignal zugeführt wird.

2. Verfahren nach Anspruch 1, **dadurch gekennzeichnet,** daß das besagte Intensitätssignal in dem ersten Regelkreis verstärkt, elektronisch verarbeitet und mit einer Zeitkonstante kleiner gleich 150 ms, vorzugsweise kleiner als 50 ms, den Reaktionsgaszufluß regelt.

3. Verfahren nach Anspruch 2, **dadurch gekennzeichnet,** daß die Messung der mindestens einen Schichteigenschaft außerhalb der Beschichtungszone erfolgt und dem zweiten Regelkreis mit einer Zeitkonstante größer gleich 0,5 sec zugeführt wird.

4. Verfahren nach Anspruch 2, **dadurch gekennzeichnet,** daß dem zweiten Regelkreis ein weiteres Meßsignal zugeführt wird, welches für die Substrateigenschaften vor dem Beschichtungsvorgang charakteristisch ist und daß das erste Meßsignal mit dem zweiten Meßsignal verglichen wird und das Vergleichsergebnis als Korrekturwert für den Sollwert des ersten Regelkreises verwendet wird.

5. Verfahren nach Anspruch 1, **dadurch gekennzeichnet,** daß nach Ablauf einer Konditionierung der Targetoberfläche Prozeßparameter in der Nähe des Arbeitspunktes für die geforderten Schichteigenschaften eingestellt werden, indem der Reaktionsgasfluß zeitlich programmiert und monoton in einer vorgegebenen Einstellzeit erhöht wird, bis ein den Sollwert der mindestens einen Schichteigenschaft in etwa bestimmenden Fluß des Reaktionsgases erreicht wird.

6. Verfahren nach Anspruch 5, **dadurch gekennzeichnet,** daß ein nach Ablauf von Konditionierzeit und Einstellzeit für den Fluß des Reaktionsgases gewonnener Istwert für das mindestens eine Intensitätssignal mit dem Sollwert für die Schichteigenschaften verglichen und aus dem Vergleichswert der Sollwert für den ersten Regelkreis gebildet wird.

7. Magnetronbeschichtungsvorrichtung zur Durchführung des Verfahrens nach Anspruch 1, **dadurch gekennzeichnet,** daß
a) ein optischer Sensor (15) einer Spektralfotometeranordnung (17) in die Reaktionszone (14) zwischen Magnetronkatode (4) und Substrat (2) gerichtet ist, wobei der Strahlengang des Sensors (15) parallel zur Targetoberfläche ausgerichtet und im Abstand von 10 bis 30 mm von dieser geführt ist,
b) eine Gasverteilungseinrichtung (9) in der Nähe der Targetoberfläche angeordnet ist, die über ein Regelventil (11) mit einer Quelle (12) für das Reaktionsgas verbunden ist,
c) der Ausgang (17a) der Spektralfotometeranordnung (17) über einen Verstärker (18) und einen Regler (19) mit einem Stellglied (20) für das Regelventil (11) verbunden ist, wobei optischer Sensor (15), Spektralfotometeranordnung (17), Verstärker (18), Regler (19), Stellglied (20) und Regelventil (11) einen ersten Regelkreis mit kurzer Zeitkonstante bilden,
d) im Wege des unmittelbar zuvor beschichteten Substrats (2) ein zweiter Sensor (21) für die mindestens eine Eigenschaft des beschichteten Substrats angeordnet ist, der einem zweiten Verstärker (23) aufgeschaltet ist, der wiederum einem Sollwertgeber (25) für den Regler (19) aufgeschaltet ist, wobei der zweite Sensor (21), der zweite Verstärker (23), der Sollwertgeber (25), der Regler (19), das Stellglied (20) und das ihm nachgeschaltete Regelventil (11) einen zweiten Regelkreis mit längerer Zeitkonstante als die des ersten Regelkreis bilden und wobei der erste und der zweite Regelkreis im Regler (19) zusammengeschaltet sind.

8. Vorrichtung nach Anspruch 7, **dadurch gekennzeichnet,** daß im Wege des Substrats (2) unmittelbar vor der aus der Magnetronkatode (4) gebildeten Beschichtungsstation ein dritter Sensor (28) für die Erfassung der Eigenschaften des in die Beschichtungsstation einlaufenden Substrats angeordnet ist, der über einen dritten Verstärker (29) dem Mikroprozessor (24) aufgeschaltet ist.

## Claims

1. Process for controlling the reactive depositing of layers on substrates with the use of magnetron cathodes with targets composed of at least one electrically conductive component of the layer material and evaluation of the intensity of at least one spectral line of the target material, which is measured in the plasma of a cathode-sputtering process between the target and substrate, and with the introduction of reaction gas controlled by a first control circuit as a function of this intensity during the layer build-up, with the shortest possible time constant and a specified reference value for said intensity, characterised in that
a) the magnetron cathode is operated at a constant output,
b) the reaction gas distribution is effected in the vicinity of the target, and
c) the reference value is set as a function of at least one property of the finished layer by a second control circuit and in a sliding manner, so that the specified layer property is as far as possible kept constant by supplying to the second control circuit a measurement signal obtained from at least one property of the finished layer.

2. Process according to claim 1, characterised in that said intensity signal is amplified in the first control circuit, is electronically processed, and controls the reaction gas inflow with a time constant of less than or equal to 150 ms, preferably less than 50 ms.

3. Process according to claim 2, characterised in that the measurement of at least one layer property takes place outside the coating zone and is fed to the second control circuit at a time constant of greater than or equal to 0.5 sec.

4. Process according to claim 2, characterised in that a further measurement signal, which is characteristic of the substrate properties before coating, is fed to the second control circuit, and in that the first measurement signal is compared to the second measurement signal, and the result of the comparison is used as a correction value for the reference value of the first control circuit.

5. Process according to claim 1, characterised in that after a time lapse for conditioning of the target surface, processing parameters are set in the vicinity of the operating site for the necessary layer properties, in that the reaction gas flow is programmed on a time basis and is monotonously increased in a specified setting time, until a flow of reaction gas approximately determining the reference value of at least one layer property is achieved.

6. Process according to claim 5, characterised in that an actual value for at least one intensity signal, obtained after the lapse of conditioning time and setting time for the flow of reaction gas, is compared to the reference value for the layer properties, and the reference value for the first control circuit is formed from the comparative value.

7. Magnetron coating device for carrying out the process according to claim 1, characterised in that
a) an optic sensor (15) of a spectral photometer device (17) is directed into the reaction zone (14) between the magnetron cathode (4) and the substrate (2), the ray path of the sensor (15) being aligned parallel to the target surface and guided at a distance of 10 to 30 mm therefrom,
b) a gas-distributing device (9) is disposed in the vicinity of the target surface and is connected via a control valve (11) to a source (12) for the reaction gas,
c) the output (17a) of the spectral photometer device (17) is connected to a servo component (20) for the control valve (11) via an amplifier (18) and a regulator (19), in which case the optic sensor (15), spectral photometer device (17), amplifier (18), regulator (19), servo component (20) and control valve (11) form a first control circuit with a short time constant,
d) in the path of the substrate (2) coated immediately beforehand, a second sensor (21) for at least one property of the coated substrate is disposed, which is connected up to a second amplifier (23), which is in turn connected to a reference value indicator (25) for the regulator (19), in which case the second sensor (21), the second amplifier (23), the reference value indicator (25), the regulator (19), the servo component (20) and the control valve (11) connected in series thereto form a second control circuit with a longer time constant than the first control circuit, and the first and second control circuit are connected together in the regulator (19).

8. Device according to claim 7, characterised in that in the path of the substrate (2), directly in front of the coating bay formed of the magnetron cathode (4), a third sensor (28) is located for detecting the properties of the substrate passing into the coating bay and is connected up to the microprocessor (24) via a third amplifier (29).

## Revendications

1. Procédé de régulation du dépôt d'une couche réactive sur des substrats en employant des cathodes de magnétron avec des anticathodes constituées d'au moins un composant électriquement conducteur du matériau de la couche, en exploitant l'intensité d'au moins une raie spectrale du matériau de l'anticathode que l'on mesure dans le plasma d'un processus de pulvérisation se produisant entre l'anticathode et le substrat, et avec une admission du gaz de réaction régulée, par un premier circuit de régulation et avec la plus brève constante de temps possible, en fonction de cette intensité pendant l'établissement de la couche, avec définition d'une valeur prescrite pour l'intensité mentionnée,
procédé caractérisé par le fait,
a) que l'on exploite la cathode du magnétron à puissance constante,
b) que la répartition du gaz de réaction s'opère au voisinage de l'anticathode et
c) que la valeur prescrite mentionnée se déplace, en glissant, sous l'action d'un second circuit de régulation, en fonction d'au moins une caractéristique de la couche finie, de façon telle que la caractéristique prescrite de la couche est maintenue aussi constante que possible, du fait qu'au second circuit de régulation on amène un signal de mesure obtenu à partir d'au moins une caractéristique de la couche finie.

2. Procédé selon la revendication 1, caractérisé par le fait que ledit signal d'intensité est amplifié dans le premier circuit de régulation, traité électroniquement et qu'il régule l'admission du gaz de réaction avec une constante de temps inférieure à 150 ms, de préférence inférieure à 50 ms.

3. Procédé selon la revendication 2, caractérisé par le fait que la mesure de la caractéristique, dont il y a au moins une, de la couche se fait en dehors de la zone de revêtement et que cette mesure est fournie au second circuit de régulation avec une constante de temps supérieure à 0,5 s.

4. Procédé selon la revendication 2, caractérisé par le fait qu'au second circuit de régulation on envoie un autre signal de mesure qui est caractéristique pour les propriétés du substrat avant le processus de revêtement et que l'on compare le premier signal de mesure avec le second signal de mesure et que l'on emploie le résultat de la comparaison comme valeur correctrice pour la valeur prescrite du premier circuit de régulation.

5. Procédé selon la revendication 1, caractérisé par le fait qu'après achèvement d'un conditionnement de la surface de l'anticathode on règle les paramètres du processus au voisinage du point de travail pour les caractéristiques demandées pour la couche, en ce sens que l'on programme en fonction du temps le débit du gaz de réaction et qu'on l'accroît de façon monotone pendant une durée prescrite du réglage, jusqu'à obtenir un débit du gaz de réaction déterminant à peu près la valeur prescrite de la caractéristique, dont il y a au moins une, de la couche.

6. Procédé selon la revendication 5, caractérisé par le fait que l'on compare une valeur réelle pour le signal d'intensité, dont il y a au moins un, obtenue après achèvement de la durée de conditionnement et de la durée de réglage du débit du gaz de réaction, avec la valeur prescrite pour les caractéristiques de la couche et qu'à partir de la valeur de la comparaison on forme la valeur prescrite pour le premier circuit de régulation.

7. Dispositif de revêtement par magnétron pour la mise en oeuvre du procédé selon la revendication 1, caractérisé par le fait:
a) qu'un capteur optique (15) d'un dispositif (17) de photométrie spectrale est orienté dans la zone de réaction (14), entre la cathode (4) du magnétron et le substrat (2), le chemin du faisceau du capteur (15) étant orienté parallèlement à la surface de l'anticathode et se trouvant à une distance de 10 à 30 mm de celle-ci,
b) qu'un dispositif (9) de répartition du gaz est disposé au voisinage de la surface de l'anticathode et qu'il est relié avec une source (12) de gaz de réaction par l'intermédiaire d'une vanne de régulation (11),
c) que la sortie (17a) du dispositif (17) de photométrie spectrale est reliée, par l'intermédiaire d'un amplificateur (18) et d'un régulateur (19) avec un organe réglant (20) pour la vanne de régulation (11), étant précisé que le capteur optique (15), le dispositif (17) de photométrie spectrale, l'amplificateur (18), le régulateur (19), l'organe réglant (20) et la vanne de régulation (11) forment un premier circuit de régulation à brève constante de temps,
d) que sur le chemin du substrat (2) qui vient d'être revêtu est disposé un second capteur (21) pour la caractéristique, dont il y a au moins une, du substrat en cours de revêtement, capteur qui est relié à un second amplificateur (23) qui lui-même est relié à un émetteur de valeur prescrite (25) pour le régulateur (25), étant précisé que le second capteur (21), le second amplificateur (23), l'émetteur de valeur prescrite (25), le régulateur (19), l'organe réglant (20) et la vanne de régulation (11) montée en aval de cet organe forment un second circuit de régulation de constante de temps plus longue que celle du premier circuit de régulation et étant précisé que le premier et le second circuits de régulation sont regroupés dans les circuits du régulateur (19).

8. Dispositif selon la revendication 7, caractérisé par le fait que sur le chemin du substrat (2), immédiatement avant la station de revêtement formée par la cathode (4) du magnétron, est disposé un troisième capteur (28) pour la saisie des caractéristiques du substrat qui parcourt la station de revêtement, capteur qui est relié au microprocesseur (24) par l'intermédiaire d'un troisième amplificateur (29).
